Europäisches Patentamt

European Patent Office

Office européen des brevets

(19)

(11) Veröffentlichungsnummer: **0 345 596 B1**

(12)
## EUROPÄISCHE PATENTSCHRIFT

(45) Veröffentlichungstag der Patentschrift: **12.05.93**

(21) Anmeldenummer: **89109684.4**

(22) Anmeldetag: **29.05.89**

(51) Int. Cl.5: **H01L 31/18**, H01L 31/02, C01B 33/02

(54) **Silicium für Solarzellen, Verfahren zu seiner Herstellung sowie dessen Verwendung.**

(30) Priorität: **10.06.88 DE 3819778**

(43) Veröffentlichungstag der Anmeldung:
**13.12.89 Patentblatt 89/50**

(45) Bekanntmachung des Hinweises auf die Patenterteilung:
**12.05.93 Patentblatt 93/19**

(84) Benannte Vertragsstaaten:
**DE ES FR IT NL**

(56) Entgegenhaltungen:
**EP−A− 0 260 424**
**DE−A− 3 504 723**
**DE−A− 3 635 064**

**PROC. 7TH E.C. PHOTOVOLTAIC SOLAR ENERGY CONFERENCE Oktober 1986, SE−VILLA, SPANIEN Seiten 1029 − 1033; J. P. STOOUERT ET AL.: "ANALYSIS OF LIGHT ELEMENTS IN SOLAR SILICON"**

(73) Patentinhaber: **BAYER AG**

**W−5090 Leverkusen 1 Bayerwerk(DE)**

(72) Erfinder: **Schwirtlich, Ingo, Dr.**
**Hausweberstrasse 26**
**W−4150 Krefeld 1(DE)**

**Beschreibung**

Die vorliegende Erfindung betrifft ein Silicium mit verbesserten fotovoltaischen Eigenschaften, Verfahren zu seiner Herstellung sowie dessen Verwendung zur Herstellung von Solarzellen.

Silicium wird in einer Vielfalt von Anwendungen eingesetzt. In der elektronischen Industrie werden hochreine Siliciumkristalle mit gezielt eingestellten elektronischen Eigenschaften verwendet. Die mit der Herstellung dieser Kristalle verbundenen hohen Kosten tragen wegen des geringen Flächenbedarfs der einzelnen elektronischen Bauelemente, die daraus hergestellt werden, nur geringfügig zu den Gesamtkosten eines einzelnen Bauteils bei. Für den Einsatz von Silicium in der Fotovoltaik wird zur Herstellung von Hochleistungs – und Konzentratorzellen ebenfalls hochreines Silicium eingesetzt. Dabei bezieht sich die Reinheit nicht auf metallische Fremdatome, Erdalkalielemente, Bor und Phosphor, sondern auch auf Kohlenstoff und Sauerstoff. Über die Wirkung von Sauerstoff und Kohlenstoff auf die elektrischen Eigen – schaften von Solarzellen ist trotz umfangreicher Literatur im Detail wenig bekannt. So werden diese beiden Elemente als ausgesprochene Störenfriede bezeichnet (D. Helmreich, H. Seiter, D. Huber and R. Wahlich, Defect Interaction in "Solar" Silicon, IEEE 1982, Seiten 405 ff).

In polykristallinem Silicium für terrestrische Solarzellen, das den wirtschaftlichen Anforderungen an eine fotovoltaische Großtechnologie genügen soll, wird man etwas höhere Sauerstoff – und Kohlenstoffgehalte akzeptieren müssen als in hochreinen Einkristallen für die Elektronikindustrie. Nachteil dieser wirtschaftlich herstellbaren Materialien sind jedoch ihre nur relativ niedrigen Wirkungsgrade.

Aufgabe dieser Erfindung ist es somit, ein für die Fotovoltaik geeignetes Silicium zur Verfügung zu stellen, mit dem verbesserte Wirkungsgrade erreicht werden können und das wirtschaftlich erhältlich ist.

Überraschenderweise wurde nun gefunden, daß nicht nur die Absolutkonzentrationen von Sauerstoff und Kohlenstoff den Wirkungsgrad des Siliciums nachhaltig beeinflussen, sondern auch ihr Verhältnis zueinan – der von großer Bedeutung ist. Selbst bei relativ hoher Konzentration beider Elemente ergeben sich überraschend hohe Wirkungsgrade, wenn das Verhältnis von Sauerstoff – zu Kohlenstoffkonzentrationen unterhalb von 2 liegt. Als Konzentrationen sind dabei die mittels Infrarot – Absorption bestimmten Werte einzusetzen.

Gegenstand dieser Erfindung ist somit ein Silicium, bei dem das Konzentrationsverhältnis des mittels IR bestimmten Sauerstoff – zu Kohlenstoffgehaltes kleiner als 2 zu 1 ist und die Gesamtkonzentration von Sauerstoff – und Kohlenstoff – Verunreinigungen zwischen 3 und 200 ppm liegt. Besonders bevorzugt ist dabei ein erfindungsgemäßes Silicium, bei dem die Gesamtkonzentration von Sauerstoff – und Kohlenstoff – Verunreinigungen zwischen 5 und 100 ppm beträgt. Besonders gute Ergebnisse sind mit Silicium zu erzielen, bei dem das Konzentrationsverhältnis in etwa 1 beträgt und die Absolutkonzentrationen der Elemente Kohlenstoff und Sauerstoff etwa 20 ppm betragen.

Gegenstand dieser Erfindung sind auch Verfahren zur Herstellung des erfindungsgemäßen Siliciums. Dieses wird vorzugsweise so hergestellt, daß zunächst der Kohlenstoffgehalt des Siliciums verringert wird und anschließend die Einstellung des Sauerstoffgehaltes durch Ausgasen von Sauerstoff erzielt wird. Die Verringerung des Kohlenstoffgehaltes kann nach dem in der DE – A 36 27 624 beschriebenen Verfahren vorteilhaft durchgeführt werden. Entsprechend dieser Verfahrensweise wird im Tiegel mit schmelzflüssigem Silicium ein Temperaturgradient zwischen Boden und Oberseite eingestellt. Der in der Schmelze vorhan – dene Kohlenstoff kristallisiert an der kühleren Seite aus. Eine weitere Möglichkeit ist in der Begasung der Siliciumschmelze mit reaktiven Gasen zu sehen, wie sie in den Deutschen Patentanmeldungen DE – A 36 35 064, DE – A 37 27 646 und DE – A 37 27 647 beschrieben sind.

Die Einstellung des Sauerstoffgehaltes kann entsprechend aus der Schmelze bei Drücken von ca. 1 mbar durch Entgasen vorgenommen werden (I.A. Amick, J.P. Dismukes, R.W. Francis, L.P. Hunt et al. Proc. of the Symp. on Materials and New Processig Technologies for Photovoltaics 1983, Vo. 83 – 11, The Elektrochemical Society Inc. 10. South Main Str., Pennington, N. J. p. p. 67).

In einer bevorzugten Ausführungsform des erfindungsgemäßen Verfahrens wird das Silicium durch die Reduktion von gasförmigen Siliciumtetrachlorid mit festem Aluminium hergestellt. Ein solches Verfahren ist aus der EP – B 123 100 bekannt.

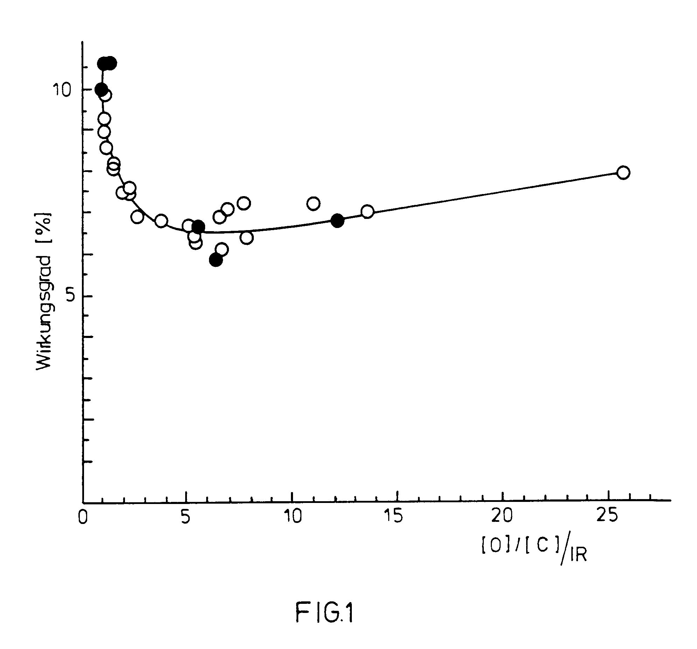

Wie aus Fig. 1 ersichtlich ist, zeigen die erfindungsgemäßen Siliciummaterialien sehr gute Wirkungs – grade. Oberhalb eines Sauerstoff – zu Kohlenstoff – Verhältnisses von größer als 2 fallen die Wirkungsgrade deutlich ab.

In der Fig. 1 sind die mittleren Wirkungsgrade einer Vielzahl von Proben sowie die in der Tabelle 1 angegebenen Werte jeweils als Funktion des Sauerstoff – zu Kohlenstoff – Verhältnisses dargestellt. Der Anstieg des mittleren Wirkungsgrades beginnt bei 2 und erreicht bei 1 maximale Werte.

Aufgrund dieser guten Wirkungsgrade ist das erfindungsgemäße Silicium hervorragend für die Herstel – lung von Solarzellen geeignet. Gegenstand dieser Erfindung ist somit die Verwendung des Siliciums zur Herstellung von Solarzellen.

In folgenden wird die Erfindung beispielhaft beschrieben, ohne das hierin eine Einschränkung zu sehen ist.

In den folgenden Beispielen sind die Analysendaten von drei Siliciumproben angegeben, aus denen Solarzellen mit Wirkungsgraden von 10 % und darüber angefertigt wurden. Bei den Sauerstoff− und Kohlenstoffwerten handelt es sich hier um IR−Daten, die im ppma angegeben werden; die Konzentrationen der anderen Elemente wurden über die Atom−Emissionslinien bestimmt. Die Konzentration ist bei diesen Werten in ppmg angegeben. Bei den Punkten handelt es sich um die Werte aus Tabelle 1, bei den Kreisen um durch Mittelwert erzielte Ergebnisse.

Tabelle 1

Beispiele

| Lfd. Nr. | IR (ppma) C | IR (ppma) O | [O]/[C] | η % | Al | B | Ca | Cr | Cu | Fe | Mg | Ni | P | Ti |
|---|---|---|---|---|---|---|---|---|---|---|---|---|---|---|
| 1 | 16,8 | 20,0 | 1,2 | 10,6 | 1,5 | 0,2 | 0,6 | <0,1 | 0,3 | 0,2 | <0,1 | <0,1 | 0,6 | 0,2 |
| 2 | 16,9 | 18,5 | 1,1 | 10,0 | 0,4 | 0,5 | 1,0 | <0,1 | 0,3 | 0,7 | 0,2 | 0,4 | 0,6 | 0,1 |
| 3 | 15,2 | 23,2 | 1,5 | 10,6 | 0,5 | 0,4 | 0,4 | <0,1 | 0,5 | 0,4 | 0,1 | <0,1 | 0,5 | 0,5 |
| 4 | 9,0 | 49,1 | 5,5 | 6,6 | 1,0 | 0,2 | <0,1 | 0,1 | <0,1 | 0,2 | 0,6 | <0,1 | 0,6 | <0,1 |
| 5 | 8,4 | 54,4 | 6,5 | 5,9 | 0,4 | 0,2 | 0,1 | 0,1 | 0,1 | 0,6 | 0,4 | <0,1 | 0,5 | 0,1 |
| 6 | 4,5 | 54,8 | 12,2 | 6,9 | 0,1 | 0,2 | <0,4 | <0,1 | 0,3 | 0,8 | 0,2 | <0,1 | 0,4 | <0,1 |

**Patentansprüche**

1. Silicium, dadurch gekennzeichnet, daß das Konzentrationsverhältnis des mittels Infrarot‑Absorption bestimmten Sauerstoff‑ zu Kohlenstoff‑Gehaltes kleiner als 2:1 ist und die Gesamtkonzentration von Sauerstoff − und Kohlenstoff − Verunreinigungen zwischen 3 und 200 ppm liegt.

2.  Silicium gemäß Anspruch 1, dadurch gekennzeichnet, daß die Gesamtkonzentration von Sauerstoff − und Kohlenstoff − Verunreinigungen zwischen 5 und 100 ppm beträgt.

3.  Verfahren zur Herstellung von Silicium nach einem der Ansprüche 1 oder 2, dadurch gekennzeichnet, daß zunächst der Kohlenstoffgehalt des Siliciums verringert wird und anschließend die Einstellung des Sauerstoffgehaltes durch Ausgasen von Sauerstoff erzielt wird.

4.  Verfahren gemäß Anspruch 3, dadurch gekennzeichnet, daß das Silicium durch die Reduktion von gasförmigem Siliciumtetrachlorid mit festem Aluminium hergestellt wurde.

5.  Verwendung des Siliciums gemäß einem oder mehrerer der Ansprüche 1 bis 4 zur Herstellung von Solarzellen.

## Claims

1.  Silicon, characterized in that the concentration ratio of the oxygen to carbon content, as determined by infrared absorption, is less than 2:1 and the total concentration of oxygen and carbon impurities is between 3 and 200 ppm.

2.  Silicon as claimed in claim 1, characterized in that the total concentration of oxygen and carbon impurities is between 5 and 100 ppm.

3.  A process for the production of the silicon claimed in claim 1 or 2, characterized in that, first, the carbon content of the silicon is reduced and the oxygen content is then established by outgassing of oxygen.

4.  A process as claimed in claim 3, characterized in that the silicon was produced by reduction of gaseous silicon tetrachloride with solid aluminium.

5.  The use of the silicon according to any of claims 1 to 4 for the production of solar cells.

## Revendications

1.  Silicium caractérisé en ce que le rapport de concentrations de la teneur en oxygène à la teneur en carbone déterminées par absorption infrarouge est inférieur à 2:1 et que la concentration totale des impuretés oxygène et carbone se situe entre 3 et 200 ppm.

2.  Silicium selon la revendication 1, caractérisé en ce que la concentration totale des impuretés oxygène et carbone se situe entre 5 et 100 ppm.

3.  Procédé de préparation de silicium selon l'une des revendications 1 ou 2, caractérisé en ce qu'on diminue tout d'abord la teneur en carbone du silicium et qu'on obtient ensuite l'ajustement de la teneur en oxygène par dégagement d'oxygène gazeux.

4.  Procédé selon la revendication 3, caractérisé en ce qu'on prépare le silicium au moyen de la réduction de tétrachlorure de silicium gazeux par de l'aluminium solide.

5.  Utilisation du silicium selon l'une ou plusieurs des revendications 1 à 4 pour la fabrication de piles solaires.

FIG.1